# EUROPÄISCHE PATENTSCHRIFT

(11) **EP 1 514 335 B1**
(45) Veröffentlichungstag und Bekanntmachung des Hinweises auf die Patenterteilung: **13.09.2006**
(21) Anmeldenummer: 03727457.8
(22) Anmeldetag: 08.05.2003
(51) Int. Cl.: H01S 5/028

(54) **VERFAHREN ZUR PASSIVIERUNG DER SPIEGELFLÄCHEN VON OPTISCHEN HALBLEITERBAUELEMENTEN**
METHOD FOR THE PASSIVATION OF THE MIRROR-TYPE SURFACES OF OPTICAL SEMI-CONDUCTOR ELEMENTS
PROCEDE DE PASSIVATION DES SURFACES REFLECTRICES DE COMPOSANTS A SEMICONDUCTEURS OPTIQUES

(30) Priorität: 13.05.2002 DE 10221952
(43) Veröffentlichungstag der Anmeldung: 16.03.2005
(73) Patentinhaber: Forschungsverbund Berlin e.V., 12489 Berlin (DE)
(72) Erfinder: RESSEL, Peter, 12557 Berlin (DE); Dr. ERBERT, Götz, 12557 Berlin (DE)
(74) Vertreter: Hengelhaupt, Jürgen
(86) Internationale Anmeldenummer: PCT/EP2003/004836
(87) Internationale Veröffentlichungsnummer: WO 2003/096498

(56) Entgegenhaltungen:
- EP-A- 0 637 862
- EP-A- 1 006 629
- WO-A-01/84680

## Beschreibung

Die Erfindung betrifft ein Verfahren zur Passivierung der Spiegelflächen von optischen Halbleiterbauelementen, nachdem diese der Luft ausgesetzt waren. Das Verfahren hat primär Bedeutung für Halbleiterlaser, ist aber auch für andere optische Halbeiterbauelemente geeignet, bei denen das Licht aus Spiegelflächen austritt, wie Superlumineszenz-Dioden, Oberflächenemittierende Diodenlaser u.a.

Optische Halbleiterbauelemente finden vielfältige Anwendung in unterschiedlichsten technologischen Gebieten wie Optische Nachrichtentechnik, Beleuchtung, Pumpen von Festkörperlasern, Materialbearbeitung oder Medizinischen Therapien. Ihre kompakte Bauart und hohe Effizienz sind von Vorteil im Vergleich mit konventionellen Lichtquellen. Insbesondere Halbleiterlaser hoher Leistung beginnen den Markt auf Gebieten zu erobern, wo ihre im Vergleich zu konventionellen Festkörper- oder Gaslasern noch immer verminderte Strahlqualität akzeptabel ist bzw. durch geeignete Maßnahmen ausgeglichen werden kann.

Lebensdauer und maximale Ausgangsleistung von Halbleiterlasern sind immer noch vor allem durch die Qualität ihrer Spiegelflächen begrenzt. Wenn diese an Luft erzeugt worden sind, insbesondere beim Brechen der Wafer in Laserriegel an Luft, entsteht auf ihnen sofort ein natürliches Oxid, fortan als Eigenoxid bezeichnet. Die Eigenoxid/Halbleiter-Grenzfläche mit ihrer hohen Dichte an Grenzflächenzuständen ist Ursache eines hohen Anteils an nichtstrahlender Rekombination. Weiterhin ist das Eigenoxid, welches auch Stoffe wie Arsen oder Wasser enthält, chemisch instabil in Bezug auf die Halbleitermaterialien, aus denen die Spiegelflächen bestehen. Bei hohen optischen Leistungsdichten führen diese Faktoren im Zusammenspiel mit der Entstehung und Wanderung von Gitterdefekten zu zwei bekannten Erscheinungen:
(a) dem kontinuierlichen Anstieg des Betriebsstroms, der für konstante Ausgangsleistung erforderlich ist (gewöhnliche Degradation der Spiegelflächen) und
(b) der plötzlichen - Zerstörung der Spiegelflächen (Catastrophic Optical Damage -COD), was zum sofortigen Ausfall des Bauelements führt.
COD ist das Resultat eines schnellen Degradationsprozesses mit starker positiver Rückkopplung, bei dem die lokale Aufheizung der Spiegelfläche infolge nichtstrahlender Rekombination an Defekten zu einer Verringerung der Bandlücke führt. Dies wiederum bewirkt noch stärkere Aufheizung, der Prozess beschleunigt sich und führt innerhalb kurzer Zeit zur Zerstörung der Spiegelfläche. Meist sinkt während des Betriebs des Bauelements die Schwelle für das Einsetzen von COD infolge gewöhnlicher Degradation. Das COD-Niveau unterschreitet irgendwann die aktuelle Ausgangsleistung und das Bauelement fällt dann aus. Die Abscheidung der Schichten zur Einstellung der Reflektivität der Spiegelflächen mit Hilfe konventioneller Techniken wie Ionenstrahl-Sputtern (IBS), Plasmagestützte Chemische Dampfphasen-Abscheidung (PECVD) o.a. ändert die Situation nicht grundlegend. Das Eigenoxid, welches Hauptursache der gewöhnlichen Degradation ist, wird lediglich durch die nachfolgenden Schichten eingeschlossen. Folglich sind optische Halbleiterbauelemente, die durch besagte Abscheidung der Schichten zur Reflektivitätseinstellung auf an Luft erzeugte Spiegelflächen gefertigt worden sind, anfällig für die o.g. Effekte von Degradation und COD, die wiederum Lebensdauer und Ausgangsleistung der Bauelemente begrenzen.

Die Lösung des Problems liegt in der Erzeugung von Spiegelflächen, welche frei von Eigenoxid und Verunreinigungen oder zumindest frei von Stoffen sind, die mit denen der Spiegelflächen reagieren können. In der Vergangenheit sind unterschiedliche Verfahren vorgeschlagen und untersucht worden, um dieses Konzept umzusetzen. Im folgenden werden solche Verfahren als Passivierung bezeichnet, welche auf die Präparation reiner Spiegelflächen in Kombination mit der Abscheidung einer Schutzschicht gerichtet sind. Die im folgenden zitierten Literaturstellen illustrieren beispielhaft die Entwicklung von Verfahren zur Passivierung und den bisher bekannten Stand der Technik.

Selbstverständlich ist die effektivste Methode zur Erzeugung reiner Spiegelflächen die Vermeidung des Kontakts mit Luft überhaupt, im Falle von kantenemittierenden Halbleiterlasern kann dies durch Brechen der Laserriegel in einer geeigneten Umgebung, insbesondere im Ultrahochvakuum, erreicht werden. In US 5,144,634 wird die in-situ Abscheidung einer geschlossenen Passivierungsschicht auf reinen Spiegelflächen beschrieben. In einer bevorzugten Realisierung geschieht dies durch Elektronenstrahl-Aufdampfung einer dünnen Si-, Ge- oder Sb-Schicht auf Spiegelflächen, die in-situ im Ultrahochvakuum erzeugt worden sind. Eine ähnliche Lösung zeigt US 5,171,717. Solcherart passivierte Bauelemente arbeiten zuverlässig bei Leistungen, die jene konventioneller Bauelemente um mehr als das Doppelte übersteigen. Allerdings wird für das Spalten von Laserriegeln im Ultrahochvakuum eine komplizierte und teure Ausrüstung benötigt. Deshalb sind auch Passivierungsverfahren entwickelt worden, die das Spalten der Riegel an Luft gestatten.

US 5,799,028 beschreibt ein Passivierungsverfahren, das auf der Behandlung von an Luft erzeugten Spiegelflächen mit schwefelhaltigen Lösungen bzw. mit H₂Se beruht, wobei die Spiegelflächen anschließend mit einer Halbleiterschicht aus GaP, InGaP, GaN, ZnSe o.a. versiegelt werden. Verschiedene Literaturstellen werden zitiert, die belegen, dass das Eigenoxid der Spiegelflächen während dieser Behandlung durch Monolagen von Schwefel bzw. Selen ersetzt wird. Solche Schichten besitzen in Kontakt mit den Halbleitermaterialien der Spiegelflächen eine niedrige Grenzflächenzustandsdichte. Doch sind sie an Luft unbeständig, weshalb es nötig ist, sofort eine inerte Schutzschicht aus einem der o.g. Materialien epitaktisch auf den Spiegelflächen aufwachsen zu lassen.

In US 5,668,049 wird die Verwendung von H₂Se- sowie H₂S-Plasmaätzen beschrieben, um das Eigenoxid auf den Spiegelflächen zu beseitigen und sie gleichzeitig mit einer dünnen Se- bzw. S-Schicht zu bedecken. Diese Se- bzw. S-Schichten bewirken eine starke Reduzierung der Grenzflächenzustandsdichte auf den Spiegelflächen und somit eine weitere Verbesserung der Reinigungswirkung besagten Plasmaätzens. Die Se- bzw. S-Schichten müssen in-situ mit einer Schutzschicht versehen werden, um eine erneute Oxidation der gereinigten Flächen an Luft zu verhindern. Obwohl die Wirksamkeit solcher Verfahren demonstriert worden ist, bergen diese oder ähnliche Techniken immer das Risiko der Erzeugung von Strahlenschäden infolge Wechselwirkung mit energiereichen Teilchen in sich, wodurch zumindest teilweise die vorteilhafte Wirkung der Reinigung der Spiegelflächen aufgehoben werden kann.

In EP 10 06 629 wird ein Verfahren zur Erhöhung von Lebensdauer und maximaler Ausgangsleistung bei Rippenwellenleiter-Halbleiterlasern gezeigt. Ein erster Reinigungsschritt für die Spiegelflächen besteht in der Behandlung mit einem niederenergetischen (25 - 300 eV) Plasma. Verbleibender Sauerstoff wird, stimuliert durch Ionenbeschuss, während des Wachstums der Passivierungsschicht in diese eingebaut. In einer bevorzugten Realisierung besteht die Passivierungsschicht aus amorphem Silizium. Dabei bewirkt der Ionenbeschuss während der ionenstrahlgestützten Abscheidung (IBAD) der Si-Schicht die gewünschte Sauerstoffgetterung infolge SiOₓ₋Bildung. XPS-Messungen zeigen, dass an der Grenze zwischen Spiegelfläche und Passivierungsschicht keine Ga-O- oder As-O-Bindungen nachgewiesen werden können, was die Wirksamkeit des Passivierungsverfahrens unter Beweis stellt.

WO 01/84680 beschreibt ein Verfahren zur Passivierung der Spiegelflächen von Halbleiterlasern, welche der Luft ausgesetzt gewesen sind. Die Spiegelflächen werden mittels eines niederenergetischen (max. 20 eV) Plasmas aus Wasserstoff oder Edelgas-Wasserstoff-Gemischen gereinigt. Ohne Unterbrechung des Vakuums wird anschließend eine inerte und für Wellenlängen >800 nm transparente Passivierungsschicht aus hydrogeniertem, amorphen Silizium (a-Si:H) aufgebracht.

Die Wirksamkeit der beispielhaft in US 5,668,049, EP 10 06 629 bzw. WO 01/84680 angegebenen Verfahren ist demonstriert worden. Doch besteht hier ein spezifisches Problem der Prozeßführung auf dem Umstand basierend, daß Partikel mit kinetischen Energien schon ab ca. 10 eV Strahlenschäden in Halbleitern hervorrufen können. Dies gilt umsomehr für Energien von 20 eV, wie in WO 01/84680, oder 25 - 300 eV wie in EP 10 06 629 angegeben. Reinigungsverfahren für Spiegelflächen, die teilweise oder ausschließlich auf der kinetischen Wirkung geladener Teilchen in Plasmen oder Ionenstrahlen beruhen, wobei die Energien zwangsläufig 20 eV oder größer sind, bergen somit das Risiko der Generation von Kristalldefekten auf den Spiegelflächen, wodurch die Wirkung des Reinigungsschritts eingeschränkt bleibt.

Die Passivierung der Spiegelflächen führt demnach zu einer Erhöhung der Lebensdauer und der Ausgangsleistung von Halbleiterlasern im Vergleich mit Bauelementen, die ohne einen Passivierungsschritt gefertigt worden sind. Das Spalten der Spiegelflächen erfolgt entweder im Ultrahochvakuum, wofür aber teure und komplizierte Ausrüstung benötigt wird, oder an Luft. Wird an Luft gespalten, ist es erforderlich, das Eigenoxid der Spaltflächen in einem speziellen Reinigungsschritt vor dem Aufbringen der Schutzschicht zu entfernen. Wie in US 5,668,049, EP 10 06 629 bzw. WO 01/84680 beispielhaft beschrieben werden für diesen Reinigungsschritt Plasmen bzw. Ionenstrahlen eingesetzt. Infolge der damit verbundenen zwangsweisen Entstehung von Kristalldefekten auf den Spiegelflächen wird das volle Potential eines solchen Reinigungsschritts aber nicht ausgeschöpft.

Es ist deshalb Aufgabe der Erfindung, ein Verfahren zur Passivierung optischer Halbleiterbauelemente anzugeben, mit dem höhere Lebensdauern und Ausgangsleistungen erreicht werden, wobei die Spiegelflächen an Luft erzeugt werden sollen. Die Reinigung der Spaltflächen vor dem Aufbringen der Schutzschicht soll auf rein chemischem Wege geschehen. Keinesfalls sollen Plasmen oder Ionenstrahlen für die Reinigung der Spaltflächen vor dem Aufbringen besagter Schutzschicht eingesetzt werden, um das gesamte Potential eines solchen Reinigungsschritts auszunützen.

Erfindungsgemäß wird die Aufgabe gelöst durch die Merkmale des Anspruchs 1. Zweckmäßige Ausgestaltungen sind Gegenstand der Unteransprüche.

Das erfindungsgemäße Verfahren beruht auf einem Zweischrittprozess. Zunächst werden die optischen Halbleiterbauelemente, deren Spiegelflächen Luft ausgesetzt gewesen sind, in eine Hochvakuumapparatur gebracht, auf Temperaturen <420 °C aufgeheizt und durch Behandlung mit einem gasförmigen, elektrisch nichtleitenden und reaktiven Medium auf rein chemischem Wege gereinigt. Damit wird die Generation von Kristalldefekten auf den Spiegelflächen während des Reinigungsschritts ausgeschlossen. Besagtes Medium besteht aus Atomen oder Molekülen, die sich im Grundzustand oder in angeregten Zuständen befinden und deren kinetische Energie Werte von 1 - 2 eV nicht überschreitet, das heißt aus neutralen Atomen oder Molekülen. Bei dem Medium handelt es sich keinesfalls um ein Plasma, einen Ionenstrahl o.ä., welche elektrisch geladene Teilchen mit Energien beinhalten, die in der Lage sind, Kristalldefekte auf den Spiegelflächen zu generieren. Das Medium ist in der Lage, mit einem oder mehreren Bestandteilen des Eigenoxids sowie anderen Verunreinigungen der Spiegelflächen zu flüchtigen Reaktionsprodukten zu reagieren. Vorzugsweise wird atomarer Wasserstoff eingesetzt, der in einem separaten Mikrowellenplasma generiert wird. Alternativ kann dieser durch Leiten des Gases über eine glühende Wendel aus Wolfram gewonnen werden. Im Anschluss wird auf die Spiegelflächen in-situ eine geschlossene, isolierende oder niedrigleitende Schutzschicht aufgebracht. Die Schutzschicht besteht aus einem Material, das chemisch inert ist in Bezug auf die Materialien der Spiegelflächen sowie eventuell verbliebener Komponenten des Eigenoxids. Des Weiteren wirkt die Schutzschicht als Barriere gegen die Eindiffusion von Verunreinigungen aus dem Äußeren, welche mit der Spiegelfläche reagieren oder sie verunreinigen können. Materialauswahl und Dicke der Schutzschicht sind so zu halten, dass möglichst hohe Lichtdurchlässigkeit besteht. Vorteilhaft, jedoch nicht zwingend, ist eine niedrige Grenzflächenzustandsdichte in Bezug auf das Halbleitermaterial. In einer bevorzugten Realisierung wird ZnSe aus einem thermischen Verdampfer aufgebracht. Andere geeignete Materialien sind Gd₂O₃, Si oder BeTe. Weicht die Reflektivität von dem Zielwert ab, können nach Abschluss der Passivierung weitere Schichten in-situ oder ex-situ aufgebracht werden, um die Reflektivität der Spiegelflächen einzustellen.

Halbleiterlaser, die mit dem erfindungsgemäßen Verfahren hergestellt worden sind, zeigen verbesserte Lebensdauern und können bei höheren Ausgangsleistungen betrieben werden als Laser, die ohne einen speziellen Passivierungsschritt gefertigt worden sind. Während die Ergebnisse vergleichbar mit denen bisher bekannter Passivierungsverfahren sind, liegt der Vorteil der Erfindung in ihrer Einfachheit. Die Spiegelflächen können mit Luft in Berührung kommen, wodurch die Notwendigkeit des Spaltens der Riegel im Ultrahochvakuum entfällt. Für die Reinigung der Spiegelflächen kommen keine energiereichen Teilchen zum Einsatz, welche Defekte auf den Spiegelflächen generieren können. Die Reinigungstemperaturen liegen unterhalb von 420 °C, d.h. Temperaturen, bei denen typische Metallkontakte noch beständig sind. Dadurch kann der Metallisierungsschritt vor dem Spalten der Wafer in Riegel ausgeführt werden, was den Fabrikationsprozess wiederum nicht unnötig kompliziert. Des Weiteren ist die Schutzschicht nicht notwendigerweise einkristallin, wodurch auf den Einsatz spezieller Ausrüstungen für die Epitaxie von Halbleiter- o.a. Schichten verzichtet werden kann. Das alles bedeutet, dass das Verfahren auf der Verwendung bekannter, kommerziell erhältlicher und vergleichsweise preiswerter Ausrüstung beruht und die Fertigung des Bauelements nicht unnötig erschwert.

Die Erfindung soll nachstehend anhand eines Ausführungsbeispiels näher erläutert werden. In den zugehörigen Zeichnungen zeigen
- Fig. 1: die schematische Darstellung eines Halbleiterlasers, der nach dem erfindungsgemäßen Verfahren gefertigt worden ist und
- Fig. 2: die Abhängigkeit des Betriebsstroms von der Alterungsdauer bei konstanter optischer Ausgangsleistung für Halbleiterlaser, die ohne einen Passivierungsschritt sowie unter Einsatz des erfindungsgemäßen Verfahrens gefertigt worden sind.

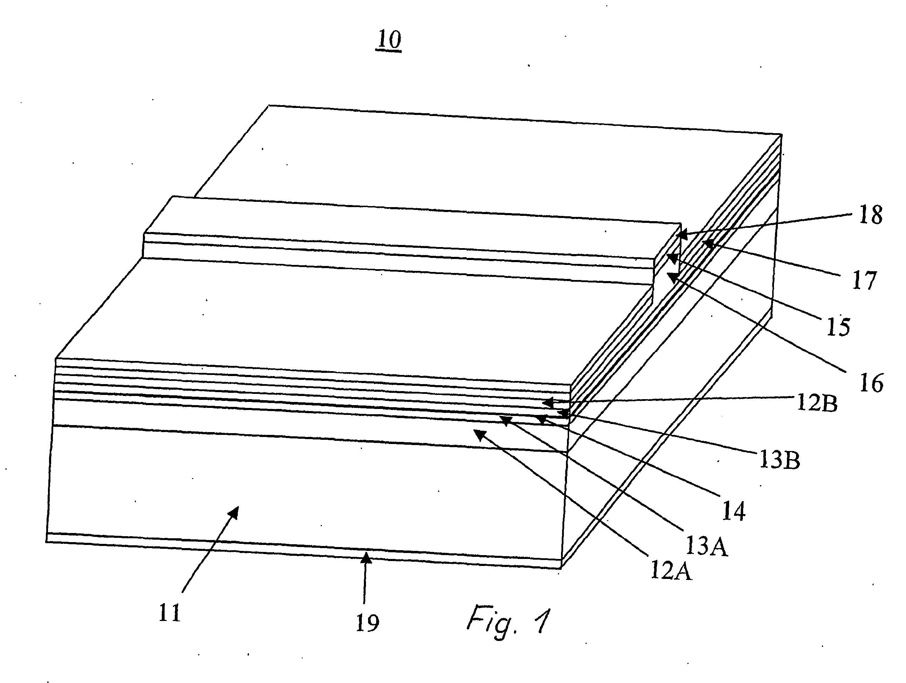

In Fig. 1 ist schematisch ein exemplarischer GaAsbasierender Halbleiterlaser 10 dargestellt. Auf einem n-GaAs (001)-Substrat 11 wird eine Anzahl von Halbleiterschichten gebildet, indem eine erste Mantelschicht 12A (AlGaAs, InGaP o.a.), eine erste Wellenleitschicht 13A (AlGaAs, InGaAsP o.a.), eine Quantentopfstruktur 14, eine zweite Wellenleitschicht 13B, eine zweite Mantelschicht 12B und eine p⁺-GaAs-Kontaktschicht 15 abgeschieden werden. Eine Mesa 16 wird bis in die zweite Mantelschicht 12B geätzt, wodurch die laterale Ausdehnung des Wellenleiters definiert wird, welcher durch Anzahl der vorgenannten Halbleiterschichten gebildet wird. Eine Isolatorschicht 17 (Al₂O₃, SiO₂ o.a.), ein p-Kontakt 18 und ein n-Kontakt 19 vervollständigen die Vielschichtstruktur, die auf diese Weise eine vorgefertigte Laserstruktur bildet. Weitere Einzelheiten der Schichtstruktur sind nicht von Bedeutung für die vorliegende Erfindung und werden hier nicht diskutiert. Die vorgefertigte Struktur wird weiter prozessiert durch Ritzen und Spalten in einzelne Riegel, welche wiederum aus einer Vielzahl von einzelnen Halbleiterlasern 10 bestehen. Auf diese Weise werden zwei gegenüberliegende Spiegelflächen erzeugt.

Die vorgefertigten Strukturen werden anschließend an Luft in Laserriegel vereinzelt, in einer geeigneten Halterung fixiert und zum Reinigen und Versiegeln der Spiegelflächen in eine Vakuumkammer gebracht. Da auf an Luft erzeugten Spiegelflächen sofort eine Schicht aus Eigenoxid und Verunreinigungen, wie Wasser u.a. entsteht, welche die Lebensdauer und Ausgangsleistung der Halbleiterlaser begrenzen, sind erfindungsgemäß eine Reinigung der Spiegelflächen und das Aufbringen einer Schutzschicht vorgesehen. Zur Reinigung wird zunächst ein reaktives, aber niederenergetisches Medium eingesetzt. Die Bezeichnung niederenergetisch bedeutet hier, dass Atome oder Moleküle besagten Mediums kinetische Energien besitzen, die Werte von 1-2 eV nicht überschreiten. In einer bevorzugten Realisierung des Verfahrens besteht das Medium aus atomarem Wasserstoff, angeregt oder im Grundzustand, oder angeregtem, molekularen Wasserstoff. Es existieren verschiedene Techniken zur Generierung von besagtem Medium, z.B. die Anregung und Dissoziation von molekularem Wasserstoff an heißen Filamenten oder durch Extraktion aus einer Gasentladung in einem Mikrowellenplasma, welche allesamt Fachleuten bekannt sind. Die Reinigungswirkung des bevorzugten Mediums entfaltet sich bereits bei Temperaturen <420 °C, weshalb keine Gefahr einer Degradation der p- und n-Kontakte 18 und 19 während des Reinigungsvorgangs besteht. Die Wirksamkeit des Reinigungsverfahrens hängt selbstverständlich vom Basisdruck in der Vakuumkammer ab. Es besteht aber keine Notwendigkeit, bei Basisdrücken zu arbeiten, wie sie für den UHV-Bereich typisch sind, d.h. Drücken <1x10⁻⁸ mbar. Deshalb wird die Vakuumkammer für das Reinigen und Versiegeln der Spiegelflächen bis zu Drücken im Hochvakuumbereich evakuiert, vorzugsweise bis zu Werten im Bereich von 1x10⁻⁸ bis 1x10⁻⁷ mbar.

Reinigung der Spiegelflächen im Sinne der vorliegenden Erfindung bedeutet nicht, dass alle Komponenten des Eigenoxids entfernt werden müssen. Das Verfahren ist hauptsächlich darauf gerichtet, eine chemisch inerte Spiegeloberfläche zu schaffen. Zu diesem Zweck müssen nur die Bestandteile des Eigenoxids bzw. die Verunreinigungen entfernt werden, welche in der Lage sind, während des Laserbetriebs mit den Spiegelflächen zu reagieren. Tatsächlich reagiert atomarer Wasserstoff (und angeregter molekularer Wasserstoff) bei Temperaturen <420 °C mit den Oxiden von As, Ga und P als auch mit As oder C, welche sich allesamt auf an Luft erzeugten Spiegelflächen von GaAsbasierenden Halbleiterlasern befinden. Er wirkt nicht in Bezug auf Al₂O₃, welches sich auf den AlGaAs-basierenden Bereichen der Spiegelflächen befindet. Somit sind Spiegelflächen rein im Sinne des Verfahrens, wenn sie frei sind von Komponenten, die eine Degradation des Lasers während des Betriebs bewirken. Doch können sie durchaus inerte Überreste des Oxidationsprozesses enthalten, welcher eine Folge des Spaltens der Laserriegel an Luft ist.

Anschließend müssen die gereinigten Spiegelflächen vor erneuter Oxidation oder Verunreinigung geschützt werden. Sinnvollerweise geschieht dies in-situ unmittelbar nach Reinigung der Flächen durch Aufbringen einer Schutzschicht. Diese Schutzschicht muss inert sein in Bezug auf die benachbarten Halbleitermaterialien sowie eventuell verbleibende Oxidschichten und sollte als Barriere gegen die Eindiffusion von Verunreinigungen aus dem Äußeren dienen. Die Schicht muss geschlossen sein sowie durchlässig für die Laserstrahlung. Weiterhin muss sie isolierend oder niedrigleitend sein, so dass während des Betriebs nur zu vernachlässigende Anteile des Stroms über die Spiegelflächen fließen. Die Schicht selbst kann amorph oder kristallin sein. Da keine explizite Notwendigkeit für das Wachsen einer einkristallinen Schicht besteht, dies ist im Falle amorpher Restschichten des Eigenoxids sogar unmöglich, ist auch keine teure und komplizierte Ausrüstung für die Abscheidung epitaktischer Schichten erforderlich. Im Gegenteil, Standardverfahren zur Schichtabscheidung wie thermische oder Elektronenstrahl-Aufdampfung bzw. Ionenstrahl-Sputtern, welche nicht auf der direkten Wechselwirkung energetischer Teilchen mit der zu beschichtenden Oberfläche beruhen, können für diesen Zweck eingesetzt werden. Das Material der Schutzschicht kann weiterhin vorteilhafterweise bezüglich einer geringen Grenzflächenzustandsdichte hinsichtlich der zu schützenden Halbleitermaterialien gewählt werden, falls die Spiegelfläche tatsächlich frei von verbliebenem Oxid ist. In diesem Fall kann eine weitere Verbesserung der Bauelementeigenschaften erwartet werden. Als bevorzugte Realisierung für die Schutzschicht ist ZnSe geeignet. Das Material ist durchlässig für Strahlung in einem weiten Bereich von Wellenlängen, wie sie typischerweise in Halbleiterlasern auftreten, und kann aus thermischen Quellen wie Knudsen-Zellen o.a. aufgebracht werden, wie sie Fachleuten bekannt sind. Vorzugsweise wird es im Anschluss an die Reinigung, d.h. in besagter Vakuumkammer auf die Spiegelflächen gedampft, welche sich dann bei Raumtemperatur oder einer beliebigen anderen Temperatur befinden, die für das Wachstum von ZnSe auf III-V-Halbleitern vorteilhaft ist. Jedoch sind andere Materialien auch für die Schutzschicht geeignet, so z.B. Gd₂O₃, Si oder BeTe.

Abschließend werden isolierende oder niedrigleitende Schichten auf den Spiegelflächen abgeschieden, die gemäß der Erfindung gereinigt und versiegelt worden sind, um die gewünschte Reflektivität einzustellen. Die Lichtaustrittsfläche wird üblicherweise entspiegelt (R < 30%), was durch Abscheidung einer einzelnen, niedrigbrechenden (n < 2) Schicht erreicht werden kann. Die Rückseite wird dann mit einer hoch reflektierenden Schichtenfolge versehen (R > 90 %). In der bevorzugten Realisierung werden Laserriegel, die gemäß der Erfindung passiviert worden sind, in eine weitere Vakuumapparatur gebracht, um dort die Schichten zur Reflektivitätseinstellung abzuscheiden. Mit Hilfe von Ionenstrahl-Sputtern wird eine einzelne Al₂O₃-Schicht auf die Lichtaustrittsfläche aufgebracht, während auf die Rückseite alternierend Schichten aus Al₂O₃ und TiO₂ abgeschieden werden. Abschließend werden die Laserriegel der Vakuumkammer entnommen, angeritzt und in einzelne Laserchips gespalten.

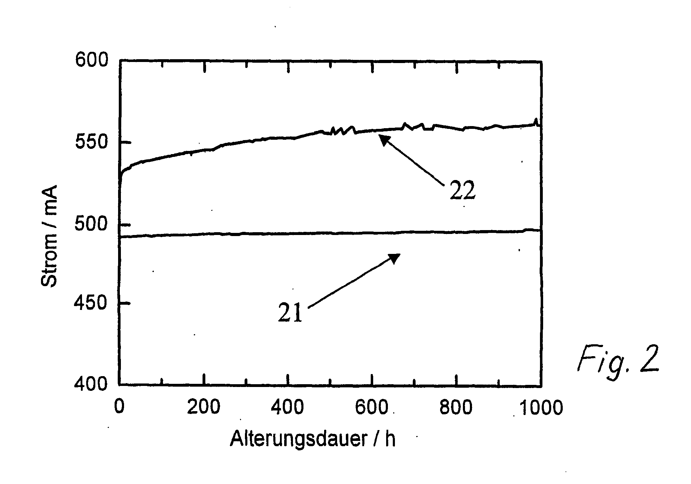

Rippenwellenleiter-Halbleiterlaser, wie sie Fig. 1 zeigt, die bei einer Wellenlänge von 980 nm emittieren, sind versuchsweise auf zwei Arten hergestellt worden: einerseits ohne einen speziellen Passivierungsschritt, zum anderen unter Anwendung des erfindungsgemäßen Verfahrens. Die Reflektivität der Lichtaustrittsflache und der Rückseite wurde auf Werte von 1 bzw. 94 % eingestellt. Laserdioden aus beiden Sätzen sind einem Alterungstest unterzogen worden, ohne ein spezielles Auswahlkriterium anzuwenden. Während des Tests, der 1000 h bei einer Temperatur von 40 °C durchgeführt wurde, ist die Ausgangsleistung der Dioden bei 300 mW stabilisiert worden. In Fig. 2 ist die Abhängigkeit des Diodenstroms von der Alterungsdauer anhand je eines passivierten Halbleiterlasers 21 bzw. nichtpassivierten 22 Halbleiterlasers dargestellt. Aus dem Zuwachs des Diodenstroms mit der Alterungszeit sind Degradationsraten für die Laser berechnet worden. Diese Raten variieren deutlich mit der Zeit bei nichtpassivierten Dioden und stabilisieren sich nach einigen hundert Stunden bei Werten im Bereich von einigen 10⁻⁵ h⁻¹. Nach Abschluss des Tests war das COD-Niveau auf Werte von 350 - 400 mW gesunken, was einen baldigen Ausfall der Dioden im Falle der Fortsetzung des Tests erwarten ließe. Die Degradationsraten passivierter Dioden stabilisieren sich jedoch recht schnell (innerhalb von etwa 200 h) bei Werten um 5x10⁻⁶ h⁻¹ oder weniger, d.h. eine Größenordnung weniger als bei nichtpassivierten Dioden. Die passivierten Dioden zeigen thermisches "Überrollen", d.h. ein Absinken der Ausgangsleistung nach Überschreiten eines kritischen Stromwerts, sogar nach Beendigung des Alterungstests. Daraus folgt, dass kein Hinweis für eine Veränderung des COD-Niveaus der Dioden im Ergebnis der Alterungsprozedur vorliegt. Sowohl die Stabilität des COD-Niveaus als auch die deutlich reduzierte Degradationsrate der passivierten Laser sind ein klarer Beleg für die Funktionstüchtigkeit des erfindungsgemäßen Verfahrens.

In dem Ausführungsbeispiel wurde die Herstellung von Halbleiterlasern mit gespaltenen Spiegelflächen beschrieben. Es soll jedoch betont werden, dass das Verfahren generell für optische Halbleiterbauelemente, wie z.B. Superlumineszenz-Dioden, Oberflächenemittierende Diodenlaser (VCSEL) u.a., anwendbar ist.

### Liste der Bezugszeichen

- 10: Halbleiterlaser
- 11: GaAs(001)-Substrat
- 12A: Erste Mantelschicht
- 13A: Erste Wellenleitschicht
- 14: Quantentopfstruktur
- 13B: Zweite Wellenleitschicht
- 12B: Zweite Mantelschicht
- 15: p⁺-GaAs-Kontaktschicht
- 16: Mesa
- 17: Isolatorschicht
- 18: p-Kontakt
- 19: n-Kontakt

## Patentansprüche

1. Verfahren zur Passivierung der Spiegelflächen von optischen Halbleiterbauelementen, nachdem diese der Luft ausgesetzt waren,
wobei
die Halbleiterbauelemente erwärmt und unter Hochvakuum mit einem gasförmigen reaktiven Medium gereinigt werden,
in-situ eine geschlossene, isolierende oder niedrigleitende, lichtdurchlässige Schutzschicht aufgebracht wird, die in Bezug auf das Material an der Spiegelfläche sowie verbliebener Komponenten des Eigenoxids inert ist,
**dadurch gekennzeichnet, dass**
das besagte gasförmige und reaktive Medium elektrisch nicht leitend und niederenergetisch ist.

2. Verfahren nach Anspruch 1,
**dadurch gekennzeichnet, dass**
als reaktives Medium Gas verwendet wird, das eine kinetische Energie hat, die kleiner als 2 eV ist.

3. Verfahren nach Anspruch 2,
**dadurch gekennzeichnet, dass**
als reaktives Medium atomarer Wasserstoff verwendet wird.

4. Verfahren nach Anspruch 2,
**dadurch gekennzeichnet, dass**
als reaktives Medium angeregter molekularer Wasserstoff verwendet wird.

5. Verfahren nach einem der vorhergehenden Ansprüche,
**dadurch gekennzeichnet, dass**
mindestens eine weitere Schicht zur Einstellung der Reflektivität aufgebracht wird.

6. Verfahren nach einem der vorhergehenden Ansprüche,
**dadurch gekennzeichnet, dass**
eine Schutzschicht aus einem der Materialien ZnSe, Gd₂O₃, Si, BeTe verwendet wird.

7. Verfahren nach einem der vorhergehenden Ansprüche,
**dadurch gekennzeichnet, dass**
die Schutzschicht aufgedampft wird.

8. Verfahren nach einem der vorhergehenden Ansprüche,
**dadurch gekennzeichnet, dass**
die Halbleiterbauelemente zum Reinigen auf eine Temperatur zwischen 350 und 420 °C erwärmt werden.

9. Verfahren nach einem der vorhergehenden Ansprüche,
**dadurch gekennzeichnet, dass**
die Halbleiterbauelemente zum Reinigen in ein Hochvakuum mit einem Bereich von 1 x 10-8 bis 1 x 10⁻⁷ mbar eingebracht werden.

10. Verfahren nach einem der vorhergehenden Ansprüche,
**dadurch gekennzeichnet, dass**
nach Abschluss der Passivierung eine oder mehrere Schichten zur Einstellung der Reflektivität aus einem oder mehreren der Materialien Al₂O₃, TiO₂, SiO₃, Ta₂O₅ oder Si aufgebracht wird.

## Claims

1. Method for the passivation of the mirror surfaces of optical semiconductor devices after the semiconductor devices had been exposed to the air, wherein
the semiconductor devices are heated and cleaned under high-vacuum with a gaseous reactive medium,
a compact, insulating or low-conductive, translucent protective layer that is inert regarding the material of the mirror surface as well as of remaining components of the self-oxide is applied in-situ;
**characterized in that** said gaseous and reactive medium is electrically non-conductive and is low energetic.

2. The method of claim 1,
**characterized in that** a gas having a kinetic energy that is less than 2 eV is used as the reactive medium.

3. The method of claim 2,
**characterized in that** atomic hydrogen is used as the reactive medium.

4. The method of claim 2,
**characterized in that** excited molecular hydrogen is used as the reactive medium.

5. The method of one of the preceding claims,
**characterized in that** at least one further layer is applied for adjusting the reflectivity.

6. The method of one of the preceding claims,
**characterized in that** a protective layer of one of the materials ZnSe, Gd₂O₃, Si, BeTe is used.

7. The method of one of the preceding claims,
**characterized in that** the protective layer is coated.

8. The method of one of the preceding claims,
**characterized in that** the semiconductor devices are heated to a temperature of 350 to 420°C for cleaning.

9. The method of one of the preceding claims,
**characterized in that** the semiconductor devices are placed in a high-vacuum in a range of 1 x 10-8 to 1 x 10⁻⁷ mbar for cleaning.

10. The method of one of the preceding claims,
**characterized in that**, after completing the passivation, one or more layers of one or more of the materials Al₂O₃, TiO₂, SiO₃, Ta₂O₅ or Si are applied for adjusting the reflectivity.

## Revendications

1. Procédé de passivation de surfaces de miroirs de composants à semi-conducteur optiques après que les composants à semi-conducteur avaient été exposé à l'air, dans lequel
les composants à semi-conducteur sont chauffés et nettoyés sous vide poussé par un milieu gazeux réactionnel,
une couche protectrice fermée, isolante ou peu conductrice, translucide, laquelle est inerte en ce qui concerne le matériau de la surface du miroir ainsi que celui de composants restants de l'oxyde spontané, est appliquée in situ,
**caractérisé en ce que** ledit milieu gazeux et réactionnel n'est pas conducteur d'électricité et qu'il est peu énergétique.

2. Procédé selon la revendication 1,
**caractérisé en ce que** du gaz ayant une énergie cinétique laquelle est inférieure à 2 eV est utilisé comme milieu réactionnel.

3. Procédé selon la revendication 2,
**caractérisé en ce que** de l'hydrogène atomique est utilisé comme milieu réactionnel.

4. Procédé selon la revendication 2,
**caractérisé en ce que** de l'hydrogène moléculaire excité est utilisé comme milieu réactionnel.

5. Procédé selon l'une des revendications précédentes,
**caractérisé en ce qu'**au moins une autre couche est appliquée pour l'ajustage de la réflectivité.

6. Procédé selon l'une des revendications précédentes,
**caractérisé en ce qu'**une couche protectrice composée d'un des matériaux ZnSe, GD₂O₃, Si, BeTe est utilisée.

7. Procédé selon l'une des revendications précédentes,
**caractérisé en ce que** la couche protectrice est vaporisée.

8. Procédé selon l'une des revendications précédentes,
**caractérisé en ce que** les composants à semi-conducteur sont chauffés à une température de 350 à 420 °C pour le nettoyage.

9. Procédé selon l'une des revendications précédentes,
**caractérisé en ce que** les composants à semi-conducteur sont placés sous un vide poussé de l'ordre de 1 x 10-8 à 1 x 10⁻⁷ mbar pour le nettoyage.

10. Procédé selon l'une des revendications précédentes,
**caractérisé en ce qu'**, après la fin de la passivation, une ou plusieurs couches d'un ou de plusieurs des matériaux Al₂O₃, TiO₂, SiO₃, Ta₂O₅ ou Si sont appliquées pour l'ajustage de la réflectivité.
